# EUROPÄISCHE PATENTANMELDUNG

(11) **EP 3 786 656 A1**
(43) Veröffentlichungstag der Anmeldung: **03.03.2021**
(21) Anmeldenummer: 20187565.5
(22) Anmeldetag: 24.07.2020
(51) Int. Cl.: G01R 31/68, G01R 31/69

(54) **VORRICHTUNG UND VERFAHREN ZUM ERKENNEN DES VORHANDENSEINS EINES STECKERS AN EINER ELEKTRONISCHEN LEITERPLATTE**

(30) Priorität: 16.08.2019 DE 102019122104
(71) Anmelder: Vaillant GmbH, 42859 Remscheid (DE)
(72) Erfinder: Grabe, Jochen, 51688 Wipperfürth (DE)
(74) Vertreter: Popp, Carsten

(57) **Zusammenfassung**

Die Erfindung betrifft eine elektronische Leiterplatte (1) aufweisend mehrere eine Kontaktleiste (22) bildende Kontakte (4, 5) zum Anschluss eines mehradrigen Kabels (8) mit einem Stecker (6) und eine Kontrolleinrichtung zum Erkennen des Vorhandenseins des Steckers (6), wobei die Kontrolleinrichtung einen Logikbaustein (11) umfasst, von dem mindestens ein Eingang (19) mit mindestens einem ersten Kontakt (12) der Kontaktleiste (22) elektrisch verbunden ist und wobei der Logikbaustein (11) dazu eingerichtet ist, elektronische Veränderungen an diesem Eingang (19) zu erkennen. Die Erfindung betrifft auch ein Verfahren zum Erkennen des Vorhandenseins eines Steckers (6) mit einem mehradrigen Kabel (8) auf einer Kontaktleiste (22) aus mehreren Kontakten (4, 5), insbesondere auf einer elektronischen Leiterplatte (1), wobei ein Logikbaustein (11) mindestens einen ersten Kontakt (12) der Kontakte (4, 5) elektronisch überwacht und aus dessen elektronischen Eigenschaften auf das Vorhandensein oder Nichtvorhandensein des Steckers (6) schließt. Auf diese Weise lässt sich auch bei einer in einem Gehäuse verbauten Leiterplatte, wenn Zugang zu deren Logikbaustein besteht, erkennen, ob ein Stecker gesteckt ist, auch wenn keine Geräte daran angeschlossen sind.

## Beschreibung

Die vorliegende Anmeldung betrifft eine Vorrichtung und ein Verfahren zum Erkennen des Vorhandenseins eines Steckers auf oder an einer elektronischen Leiterplatte.

Die Anwendung von Leiterplatten in der Elektronik oder in der industriellen Praxis ist sehr häufig. Fast jedes elektronische Gerät enthält eine oder mehrere Leiterplatten. Daher ist eine beliebige vielfältige Erweiterung und Verbindung von Leiterplatten (d.h. Verbindung mit Peripheriegeräten oder anderen Leiterplatten für einen flexiblen Aufbau oder Umbau einer Funktionsschaltung) unumgänglich.

Dafür wird eine Mehrzahl von (meist rechteckigen) Metallkontakten üblicherweise in Reihen auf oder neben dem Rand einer Leiterplatte angeordnet, und die Metallkontakte werden z. B. durch Galvanisierung mit einer Nickel-Gold-Schicht auf einem Grundmaterial, meistens Kupfer, gebildet. Mithilfe eines oder mehrerer Stecker können Leiterplatten miteinander oder mit Peripheriegeräten elektrisch verbunden werden.

Ein solcher Stecker umfasst typischerweise ein isolierendes Gehäuse mit einer schlitzförmigen Aufnahmenut für die Metallkontakte am Leiterplattenrand, welche sich in Längsrichtung innerhalb des Steckers erstreckt. Auf den gegenüberliegenden Seiten der Aufnahmenut sind normalerweise mehrere leitende Kontakte zur Verbindung mit einem Kabelbaum vorgesehen, wodurch eine elektrische Verbindung mit bspw. einem Peripheriegerät ermöglicht wird.

Eine Erkennung, ob ein Stecker eines Kabelbaums aufgesteckt ist, kann optisch oder über die elektrische Funktion der angeschlossen Aktuatoren oder Sensoren oder über Messung elektrischer Signale an der Kabelbaumseite der Schnittstelle erfolgen. D.h. eine Erkennung, ob der Stecker gesteckt ist, kann somit elektrisch nur festgestellt werden, wenn die Gegenseite kontaktiert wird.

Ein technisches Problem ist, dass heutzutage Leiterplatten (auch in fertigen Anlagen) ausgeliefert werden, welche mit einem Stecker an einen Kabelbaum adaptiert sind, der an der Gegenseite zur Nachrüstung von Zubehören (noch) nicht beschaltet ist.

Insbesondere für Elektrogeräte, die mit Leiterplatten ausgestattet sind, werden manchmal unverbundene Stecker an der Leiterplatte als Schnittstellen vorgesehen, welche zu unterschiedlichen Anlässen und Anwendungen mit anderen Geräten verbunden werden können. Darüber hinaus sind die Stecker oft im Inneren eines Gehäuses eingeschlossen. Dann ist es mit herkömmlichen Methoden schwer zu erkennen, ob ein Stecker aufgesteckt ist oder nicht. In diesem Fall ist es wünschenswert, eine einfache Lösung zu finden, das Vorhandensein eines Steckers festzustellen.

Die vorliegende Vorrichtung und das zugehörige Verfahren stellen eine Lösung zu dieser bisher im Stand der Technik nicht diskutierten Aufgabe der Anwesenheitsüberprüfung eines Steckers bei einer Leiterplatte dar, wenn die Gegenseite des Steckers nicht mit anderen Geräten verbunden ist.

Hiervon ausgehend werden hier eine besonders vorteilhafte Vorrichtung und ein besonders vorteilhaftes Verfahren zur Erkennung des Vorhandenseins eines Steckers bei einer elektronischen Leiterplatte beschrieben.

Es wird eine erfindungsgemäße elektronische Leiterplatte beschrieben aufweisend mehrere eine Kontaktleiste bildende Kontakte zum Anschluss eines mehradrigen Kabels mit einem Stecker und eine Kontrolleinrichtung zum Erkennen des Vorhandenseins des Steckers, wobei die Kontrolleinrichtung einen Logikbaustein umfasst, von dem mindestens ein Eingang mit mindestens einem ersten Kontakt der Kontaktleiste elektrisch verbunden ist und wobei der Logikbaustein dazu eingerichtet ist, elektronische Veränderungen an diesem Eingang zu erkennen.

Der Begriff "elektronische Leiterplatte" meint hier insbesondere einen Träger für elektronische Bauteile, welche der mechanischen Befestigung und elektrischen Verbindung dient, und nahezu fast in jedem elektronischen Gerät vorkommt. Moderne Leiterplatten tragen auf einer Oberseite und einer Unterseite Verbindungen, Bauelemente und Kontakte.

Der Begriff "Kontakte" meint hierbei insbesondere eine Mehrzahl von meist rechteckigen Metallkontakten, die üblicherweise in Reihen neben dem Rand der Leiterplatte angeordnet sind. Ein oder mehrere Kontakte neben dem Rand der Leiterplatte bilden zusammen eine sogenannte "Kontaktleiste", dadurch kann die Leiterplatte mit Peripheriegeräten mithilfe eines oder mehrerer Stecker elektrisch verbunden werden. Der Stecker kann z.B. ein Randstecker sein und umfasst typischerweise ein isolierendes Gehäuse mit einer Aufnahmenut für Kontakte am Leiterplattenrand, welche sich in Längsrichtung innerhalb des Steckers erstreckt. Auf den gegenüberliegenden Seiten der Aufnahmenut sind normalerweise mehrere Buchsen zur Aufnahme eines "mehradrigen Kabels" (Kabelbaum) vorgesehen. Dadurch wird eine elektrische Verbindung zwischen der Leiterplatte und bspw. einem Peripheriegerät ermöglicht.

Um zu erkennen, ob der Stecker auf der Leiterplatte aufgesteckt ist oder nicht, insbesondere im leerlaufenden Zustand, d.h. wenn der Stecker nicht mit anderen Geräten verbunden ist, steht eine auf der Leiterplatte zugeordnete Kontrolleinrichtung zur Verfügung, welche einen Logikbaustein umfasst. Der Logikbaustein kann eine beliebige Auswerteschaltung zur Erkennung von Signalen an Eingängen in Form von Spannungspotentialen sein. Ein wichtiges Beispiel für einen solchen Logikbaustein ist ein Mikroprozessor. Der Logikbaustein kann also ein Mikroprozessor sein. Wenn im Folgenden ein Mikroprozessor und dessen Funktionen im Rahmen der Erfindung und Vorteile etc. erläutert werden, bezieht sich dies immer auch auf andere Arten von Logikbausteinen. Andere Arten von Logikbausteinen sind beispielsweise manuelle Auswerteschaltungen oder Auswerteschaltungen, die aus einzelnen elektronischen Komponenten aufgebaut sind. Ein Mikroprozessor ist im Wesentlichen eine integrierte Schaltung, die Daten entgegen nimmt, diese anhand von Befehlen verarbeitet und die erhaltenen Ergebnisse wieder ausgibt. Hierbei kann z.B. mindestens ein Eingang des Mikroprozessors mit einem Kontakt der Kontaktleiste elektrisch verbunden werden, sodass die elektronischen Eigenschaften, wie z.B. Spannung, Frequenz, Phase von einem Strom an diesem Kontakt als Eingabedaten im Mikroprozessor eingegeben werden. Dieser Kontakt wird hiermit als der "erste Kontakt" bezeichnet.

Das Grundprinzip zur Überwachung des Vorhandenseins eines Steckers anhand des auf der Leiterplatte befindlichen Mikroprozessors besteht darin, dass die am ersten Kontakt angeschlossene Schaltung je nach dem Vorhandensein oder Nichtvorhandensein des Steckers unterschiedlich ist, sodass die elektronischen Eigenschaften am Eingang des Mikroprozessors sich entsprechend ändern. Durch Feststellung der elektronischen Veränderungen am ersten Kontakt wird das Vorhandensein oder Nichtvorhandensein des Steckers erkannt.

In einer bevorzugten Ausführungsform der elektronischen Leiterplatte verbindet der Stecker in einem aufgesteckten Zustand den ersten Kontakt mit einem definierten Spannungspotential, welches verschieden ist von dem Spannungspotential des ersten Kontaktes ohne Stecker.

Da das gesamte Stromversorgungssystem für alle Bauteile der Leiterplatte eine stabile Spannung gewährleisten muss, wird bevorzugt eine Spannungspotentialanalyse mit geringem Aufwand ausgeführt. Hierbei kann z.B. der erste Kontakt mit einem definierten Spannungspotential belegt werden, welches beim Vorhandensein oder Nichtvorhandensein des Steckers unterschiedlich ist, sodass der Mikroprozessor aufgrund der Änderung das Vorhandensein oder Nichtvorhandensein des Steckers schließen kann.

In einer weiteren bevorzugten Ausführungsform weist die elektronische Leiterplatte eine Oberseite und eine Unterseite mit elektrischen Leiterbahnen auf, wobei die Kontaktleiste sich jeweils gegenüber liegende Kontakte auf der Oberseite und der Unterseite hat und wobei mindestens der erste Kontakt auf der Oberseite von einem ihm gegenüberliegenden zweiten Kontakt auf der Unterseite elektrisch getrennt ist und im Betrieb ohne Stecker der erste Kontakt und der zweite Kontakt mit unterschiedlichen Spannungspotentialen beschaltet sind.

Eine elektronische Leiterplatte umfasst zwei Seiten, hiermit wird die Seite mit dem Mikroprozessor die "Oberseite" bezeichnet. Und die andere Seite ist die "Unterseite". Bevorzugt weisen beiden Seiten jeweils elektrische Leiterbahnen auf. Es ist aber auch möglich, dass Leiterbahnen überwiegend (oder vollständig) nur auf einer Seite vorgesehen sind und Bauteile (wie der Mikroprozessor) auf der anderen Seite angeordnet sind.

Die Enden der Leiterbahnen, insbesondere im Rangbereich der Leiterplatte zur elektronischen Verbindung mit z.B. den Peripheriegeräten, werden i.d.R. mit metallbasierten Kontaktflächen verbunden, wobei die Breite der Kontaktfläche viel größer als die Breite der Leiterbahn ist. Diese Kontaktflächen werden hiermit als "Kontakte" bezeichnet. Mehrere Kontakte bilden zusammen am Randbereich eine "Kontaktleiste", darauf kann ein Stecker einfach aufgeschoben werden.

Bevorzugt hat die Kontaktleiste Kontakte auf der Oberseite und der Unterseite, die sich jeweils gegenüber liegen. D.h. ein Kontakt hat immer einen korrespondiert ausgeführten Kontakt, der auf der gleichen vertikalen Achse auf der anderen Seite der Leiterplatte befindlich ist.

Der "erste Kontakt" meint hierbei insbesondere den Kontakt, der auf der Oberseite mit dem Eingang des Mikroprozessors verbunden ist. Der "zweite Kontakt" ist der Kontakt, der auf der Unterseite und nicht durch die elektronische Leiterplatte mit dem ersten Kontakt verbunden ist, und zwar im Betrieb ohne Stecker die beiden Kontakte mit unterschiedlichen Spannungspotentialen beschaltet sind. Damit, dass die Kontakte nicht miteinander verbunden sind, ist gemeint, dass die elektrischen Kontakte voneinander elektrisch getrennt sind. Allerdings besteht natürlich eine Verbindung der beiden elektrischen Kontakte an der Auswertlogik, die dazu dient, die Potentiale, welche an den elektrischen Kontakten (erster elektrischer Kontakt und zweiter elektrischer Kontakt) anliegen, miteinander zu vergleichen. Mit der Formulierung "voneinander elektrisch getrennt" ist insbesondere auch gemeint, dass keine direkte Verbindung zwischen den beiden Kontakten existiert und genau diese Verbindung durch das Aufsetzen des Steckers dann hergestellt wird.

Besonders vorteilhaft ist die elektronische Leiterplatte, wenn die Kontaktleiste eine Mehrzahl gegenüberliegender Kontakte auf der Oberseite und der Unterseite hat, die jeweils sich gegenüber liegende Paare von Kontakten bilden, wobei nur ein Teil der sich gegenüber liegenden Paare von Kontakten erste Kontakte und zweite Kontakte bilden, die mit dem Logikbaustein verbunden sind. Bevorzugt bilden Paare von ersten Kontakten und zweiten Kontakten jeweils Angriffspunkte für Kontaktklammern von Steckern, die auf den Rand der Leiterplatte aufgesetzt werden können. Bevorzugt ist nur ein Teil dieser Paare von Kontakten als erste Kontakte und zweite Kontakte ausgebildet mit welchen wie beschrieben erkannt werden kann, ob ein Stecker auf den Rand der Leiterplatte aufgesetzt ist. Besonders bevorzugt ist sogar nur ein Paar von Kontakten so ausgebildet mit dem Logikbaustein verbunden. Weiterhin besonders bevorzugt sind die Paare von Kontakten, die dazu ausgebildet sind, zu erkennen, ob ein Stecker aufgesetzt ist bzw. die mit dem Logikbaustein verbunden sind, so angeordnet, dass ein sicherer Halt des Steckers erkannt werden kann. Beispielsweise ist es möglich, dass jeweils äußere Paare von ersten Kontakten und zweiten Kontakten dazu ausgebildet sind, zu erkennen, ob ein Stecker aufgesetzt bzw. mit dem Logikbaustein verbunden ist.

Besonders bevorzugt ist, wenn der Logikbaustein in der Lage ist, elektronische Änderungen, die durch eine mit einer Kontaktklammer in einem Stecker hergestellte elektrische Verbindung zwischen einem ersten Kontakt auf der Oberseite und einem zweiten Kontakt der Unterseite zu erkennen und anhand von solchen erkannten Veränderungen, das Vorhandensein des Steckers zu signalisieren. In Ausführungsvarianten ist hierbei vorteilhaft, wenn die elektrische Verbindung unmittelbar durch die Kontaktklammer in dem Stecker hergestellt wird und nicht erst durch eine entfernter angeordnete elektrische Verbindung, die bspw. in einer mit dem Stecker über das mehradrige Kabel verbundene weitere Platine hergestellt wird. Durch die direkte Verbindung mit der Kontaktklammer kann das Vorhandensein des Steckers auf sehr einfache Art geprüft werden.

In einer weiteren bevorzugten Ausführungsform weist der Stecker eine Kontaktklammer zur Verbindung des ersten Kontaktes mit mindestens einem zweiten Kontakt auf.

Besonders bevorzugt ist, wenn der Stecker an ein mehradriges Kabel angeschlossen ist, wobei für jede Ader eine Kontaktklammer vorgesehen ist. In diesem Zusammenhang ist bevorzugt, dass nur ein Teil und ganz besonders bevorzugt nur eine oder zwei der Kontaktklammern in dem Stecker dafür vorgesehen sind, erste elektrische Kontakte und zweite elektrische Kontakte mit dem Ziel der Steckererkennung durch den Logikbaustein zu verbinden.

Weiter bevorzugt weist der Stecker eine Aufnahmenut auf, mit der der Stecker einfach auf die Kontaktleiste aufgeschoben werden kann, wobei innerhalb der Aufnahmenut mindestens eine Kontaktklammer vorgesehen ist. Bevorzugt ist die Aufnahmenut dazu eingerichtet den Rand der elektronischen Leiterplatte mit den ersten Kontakten und den zweiten Kontakten zu umgreifen.

Zum Anschließen derLeiterplatte weist der Stecker eine vorzugsweise Aufnahmenut auf, damit der Stecker einfach auf die Kontaktleiste aufgeschoben werden kann. Zur elektrischen Kontaktierung ist innerhalb der Aufnahmenut mindestens eine Kontaktklammer vorgesehen, welche bei einem typischen Leiterplatten-Rand-Steckverbinder auch dazu dient, die Leitungen anzuschließen. Dadurch werden der erste Kontakt und der zweite Kontakt bei dem korrekten Aufstecken des Steckers elektrisch verbunden.

In einer weiteren bevorzugten Ausführungsform ist eine Schaltung vorgesehen, wobei der erste Kontakt über einen ersten Widerstand mit einem positiven Spannungspotential, und der zweite Kontakt mit Masse oder einem negativen Spannungspotential oder umgekehrt verbunden ist.

In der vorliegenden Vorrichtung wird eine Spannungspotentialanalyse vorgenommen, wobei der erste Widerstand gewissermaßen zum Schutz des Mikroprozessor-Eingangs dient und zusammen mit einem Kondensator einen Tiefpassfilter bildet.

Der Kondensator ist zur Entstörung vorgesehen, wobei der Kondensator die beiden Eingänge des Mikroprozessors (Logikbausteins) miteinander verbindet. So ist eine Schaltung gebildet, die zur Abschwächung von unerwünschten Störungen, insbesondere von den Halbleiterkomponenten des Mikroprozessors dient.

Weiter bevorzugt kann ein zweiter Widerstand als Pull-up Widerstand stromversorgungsseitig in Reihe geschaltet werden, um das Potential am ersten Kontakt anzuheben.

Ferner ist der dem ersten Kontakt gegenüberliegende zweite Kontakt mit einem Erdleiter oder mit einem negativen Spannungspotential zur Ausbildung einer Potentialdifferenz verbunden. Bei Vorhandensein des Steckers werden der erste Kontakt und der zweite Kontakt kurzgeschlossen, sodass ein Stromkreis durch die Potentialdifferenz gebildet wird und die Spannung als Eingabewert am Eingang in den Mikroprozessor anliegt.

Hier auch beschrieben wird ein System bestehend aus einer beschriebenen elektronischen Leiterplatte und einem beschriebenen Stecker.

In einer weiteren bevorzugten Ausführungsform wird ein Verfahren zum Erkennen des Vorhandenseins eines Steckers mit einem mehradrigen Kabel auf einer Kontaktleiste aus mehreren Kontakten beschrieben, insbesondere auf einer elektronischen Leiterplatte wobei ein Mikroprozessor mindestens einen ersten Kontakt der Kontakte elektronisch überwacht und aus dessen elektronischen Eigenschaften auf das Vorhandensein oder Nichtvorhandensein des Steckers schließt.

Das Grundprinzip zum Erkennen des Vorhandenseins eines Steckers besteht darin, dass mindestens ein der Oberseitenkontakte und mindestens ein der Unterseitenkontakte unterschiedliche Signale führen, wenn der Stecker nicht vorhanden ist. Die Oberseitenkontakte sind die Kontakte, die sich auf der Oberseite befinden. Und die Unterseitenkontakte sind die Kontakte, die sich auf der Unterseite befinden. Durch das Aufstecken des Steckers werden die beiden Kontakte verbunden (kurzgeschlossen), sodass die beiden Kontakte dasselbe Signal führen. Durch Erkennung dieser Signaländerung wird das Vorhandensein des Steckers erkannt.

Hierbei kann ein Eingang des Mikroprozessors bzw. des Logikbaustein mit einem Oberseitenkontakt als der "erste Kontakt" verbunden werden, damit der Mikroprozessor anhand des Signals (d.h. elektronische Eigenschaften) an diesem Kontakt auf das Vorhandensein oder Nichtvorhandensein des Steckers schließen kann. Die Kontakte können auch umgekehrt auf der Oberseite und der Unterseite angeordnet sein. So kann der erste Kontakt auf der Unterseite angeordnet sein und der zweite Kontakt kann auf der Oberseite angeordnet sein.

In einer weiteren bevorzugten Ausführungsform werden der erste Kontakt und ein zweiter Kontakt mit unterschiedlichen elektrischen Bauelementen verbunden, damit die beiden Kontakte mit unterschiedlichen elektrischen Bauelementen beschaltet werden. Der "zweite Kontakt" ist ein Unterseitenkontakt, der nicht mit dem ersten Kontakt durch die elektronische Leiterplatte verbunden ist.

In einer weiteren bevorzugten Ausführungsform werden der erste Kontakt über mindestens einen Widerstand mit einem positiven Spannungspotential und der zweite Kontakt an ein Vergleichspotential (Masse oder ein negatives Spannungspotential) angeschlossen.

Durch den Anschluss mit einem positiven Spannungspotential am ersten Kontakt und mit einem Erdleiter oder negativen Spannungspotential am zweiten Kontakt wird ein Potentialabfall gebildet. Darüber hinaus durch das Aufstecken des Steckers werden die beiden Kontakte kurzgeschlossen, sodass ein Stromkreis gebildet wird. Dadurch können die elektronischen Eigenschaften am ersten Kontakt in Form einer Spannung vom Mikroprozessor erfasst werden.

Dafür wird mindestens ein Widerstand als Schutzwiderstand und/oder als Entkopplungswiderstand eingebaut, der zusammen mit einem Kondensator zur Abschwächung von unerwünschten Störungen, insbesondere von den Halbleiterkomponenten des Mikroprozessors dient.

In einer weiteren bevorzugten Ausführungsform erfasst der Mikroprozessor das Spannungspotential am ersten Kontakt und erkennt daraus das Vorhandensein oder Nichtvorhandensein eines Steckers und leitet diese Information weiter.

Hierbei erfasst der Mikroprozessor durch die oben beschriebene Schaltung das Spannungspotential am ersten Kontakt.

Hierbei kann ein Ausführungsprogramm im Mikroprozessor vorgespeichert werden, wobei die angeschlossene positive Spannung als Referenzpotential angewendet werden kann. Nach dem Auslösen des Ausführungsprogramms vergleicht der Mikroprozessor das erfasste Potential mit dem Referenzpotential, um eine Potentialdifferenz zu ermitteln. Das Ausführungsprogramm kann bspw. vom Benutzer anhand einer Anzeigeeinrichtung, die drahtlos mit dem Mikroprozessor verbunden ist, ausgelöst werden.

Wenn die angeschlossene Spannung eine positive Gleichspannung ist, wird der Strom in der oben beschriebenen Schaltung von dem Kondensator gesperrt, sodass beim Nichtvorhandensein des Steckers kein Strom fließt und die Potentialspannung sich nicht ändert.

Beim Vorhandensein des Steckers werden der erste Kontakt und der zweite Kontakt kurzgeschlossen, sodass ein Stromkreis gebildet wird. Der angeschlossene Widerstand wandelt den Strom in Spannung um, sodass das Spannungspotential wegen des Widerstands kleiner geworden ist.

Die Vorrichtung und das Verfahren zum Erkennen des Vorhandeneins eines Steckers auf einer Leiterplatte werden nachfolgend anhand der Figuren näher erläutert. Es ist darauf hinzuweisen, dass die Figuren nur bevorzugte Ausführungsbeispiele zeigen, auf welche die Offenbarung hier jedoch nicht beschränkt ist. Es zeigen:
Fig. 1: eine schematische Darstellung einer Leiterplatte und eines Steckers zur Durchführung des beschriebenen Verfahrens und
Fig. 2: eine schematische Darstellung einer Schaltung zum Erkennen des Vorhandenseins eines Steckers.

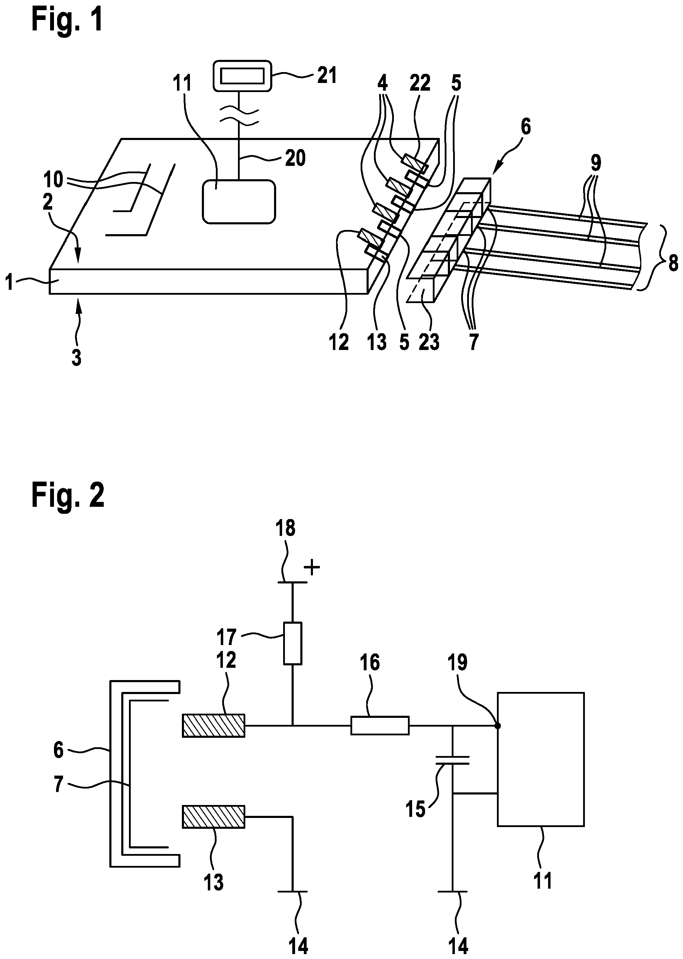

Fig. 1 stellt schematisch eine Leiterplatte 1 und einen Stecker 6 dar, wobei die Leiterplatte 1 eine Oberseite 2 und eine Unterseite 3 als Bestückungsseite für Bauteile und für Lötverbindungen umfasst, dazwischen sind die Leiterbahnen 10 befindlich. Im Randbereich der Leiterplatte 1 befinden sich Kontaktflächen, die als Kontakte 4, 5 bezeichnet werden. Die Kontakte, die auf der Oberseite 2 nebeneinander mit Abstand zugeordnet sind, sind die Oberseitenkontakte 4. Die Kontakte, die auf der Unterseite 3 nebeneinander mit Abstand angeordnet sind, sind die Unterseitenkontakte 5. Die Oberseitenkontakte 4 und die Unterseitenkontakte 5 sind so korrespondierend ausgeführt, dass für jeden Oberseitenkontakt 4 ein gegenüberliegender Unterseitenkontakt 5 vorgesehen ist. D.h. die Oberseitenkontakte 4 und die Unterseitenkontakte 5 sind immer paarweise ausgeführt, und typischerweise auch paarweise elektrisch verbunden, so dass an jedes Paar eine Ader 9 eines mehradrigen Kabels 8 angeschlossen werden kann. Die Oberseitenkontakte 4 und die Unterseitenkontakte 5 bilden zusammen eine Kontaktleiste 22, auf die ein Stecker 6 aufgesteckt werden kann. Der Stecker 6 weist eine schlitzförmige Aufnahmenut 23 auf, in der die Kontaktklammern 7 ebenfalls entsprechend den Kontakten 4, 5 nebeneinander mit Abstand angeordnet sind. Die Leiterplatte 1 umfasst einen Logikbaustein (z.B. Mikroprozessor) 11, der den ersten Kontakt 12 überwacht, indem der erste Kontakt 12 mit einem Logikbaustein-Eingang 19 verbunden ist. Der zweite Kontakt 13 liegt gegenüber dem ersten Kontakt 12 und ist nicht durch die Leiterplatte 1 mit dem zweiten Kontakt 13 direkt verbunden bzw. getrennt, so das im Betrieb ohne Stecker 6 der erste Kontakt 12 und der zweite Kontakt 13 mit unterschiedlichen Spannungspotentialen beschaltet sein können. Der Logikbaustein 11 weist noch eine Verbindung 20 (drahtlos oder kabelgebunden) zu einem Benutzer auf mit einer Anzeigereinrichtung 21, damit der Benutzer die Information über das Vorhandensein des Steckers 6 erhalten kann.

Fig. 2 stellt eine Schaltung zum Erkennen des Vorhandenseins eines Steckers dar, wobei der erste Kontakt 12 und der zweite Kontakt 13 durch die Kontaktklammer 7 des Steckers 6 kurzgeschlossen werden. Der erste Kontakt 12 ist mit einem ersten Widerstand 16 in Serie mit dem Logikbaustein-Eingang 19 verbunden. Der zweite Kontakt 13 ist mit einem Vergleichspotential 14 verbunden, welches beispielsweise eine Masse sein kann aber auch ein negatives Spannungspotential oder ein beliebiges Spannungspotential, welches sich (so lange der erste Kontakt 12 und der zweite Kontakt 13 getrennt) sind von dem Spannungspotential am ersten Kontakt 12 unterscheidet. Der erste Kontakt 12 ist ebenfalls mit dem Vergleichspotential 14 fest verbunden allerdings über einen Kondensator 15. Auf diese Weise wird eine RC-Schaltung zur Abschwächung von unerwünschten Störungen durch die Halbleiterkomponenten im Logikbaustein11 gebildet. Zwischen dem ersten Kontakt 12 und dem ersten Widerstand 16 ist ein Potentialschluss 18 mit einem positiven Spannungspotential vorgesehen, der mit dem zweiten Widerstand 17 mit dem ersten Widerstand 16 verbunden ist.

Der zweite Kontakt 13 und ein Ende des Kondensators 15 sowie ein Eingang des Logikbausteins 11 werden zur Ausbildung eines Stromkreises ebenfalls mit dem Vergleichspotential 14 verbunden.

Auf diese Weise lässt sich auch bei einer in einem Gehäuse verbauten Leiterplatte 1, wenn Zugang zu deren Logikbaustein 11 besteht, erkennen, ob ein Stecker 6 gesteckt ist, auch wenn keine Geräte daran angeschlossen sind.

### Bezugszeichenliste

- 1: elektronische Leiterplatte
- 2: Oberseite
- 3: Unterseite
- 4: Oberseitenkontakt
- 5: Unterseitenkontakt
- 6: Stecker
- 7: Kontaktklammer
- 8: mehradriges Kabel
- 9: Adern
- 10: Beschaltung, Leiterbahnen
- 11: Logikbaustein
- 12: erster Kontakt
- 13: zweiter Kontakt
- 14: Vergleichspotential
- 15: Kondensator
- 16: erster Widerstand
- 17: zweiter Widerstand
- 18: Potentialanschluss
- 19: Logikbaustein-Eingang
- 20: Verbindung zum Benutzer
- 21: Anzeigeeinrichtung
- 22: Kontaktleiste
- 23: Aufnahmenut

## Patentansprüche

1. Elektronische Leiterplatte (1) aufweisend mehrere eine Kontaktleiste (22) bildende Kontakte (4, 5) zum Anschluss eines mehradrigen Kabels (8) mit einem Stecker (6) und eine Kontrolleinrichtung zum Erkennen des Vorhandenseins des Steckers (6), wobei die Kontrolleinrichtung einen Logikbaustein (11) umfasst, von dem mindestens ein Eingang (19) mit mindestens einem ersten Kontakt (12) der Kontaktleiste (22) elektrisch verbunden ist und wobei der Logikbaustein (11) dazu eingerichtet ist, elektronische Veränderungen an diesem Eingang (19) zu erkennen.

2. Elektronische Leiterplatte (1) nach Anspruch 1, wobei der Stecker (6) in einem aufgesteckten Zustand den ersten Kontakt (12) mit einem definierten Spannungspotential verbindet, welches verschieden ist von dem Spannungspotential des ersten Kontaktes (12) ohne Stecker (6).

3. Elektronische Leiterplatte (1) nach Anspruch 1 oder 2, wobei die elektronische Leiterplatte (1) eine Oberseite (2) und eine Unterseite (3) mit elektrischen Leiterbahnen (10) aufweist, wobei die Kontaktleiste (22) sich jeweils gegenüber liegende Kontakte (4, 5) auf der Oberseite (2) und der Unterseite (3) hat und wobei mindestens ein erster Kontakt (12) auf der Oberseite (2) von einem ihm gegenüberliegenden zweiten Kontakt (13) auf der Unterseite (3) elektrisch getrennt ist und im Betrieb ohne Stecker (6) der erste Kontakt (12) und der zweite Kontakt (13) mit unterschiedlichen Spannungspotentialen beschaltet sind.

4. Elektronische Leiterplatte (1) nach Anspruch 3, wobei die Kontaktleiste (22) eine Mehrzahl gegenüberliegender Kontakte (4, 5) auf der Oberseite (2) und der Unterseite (3) hat, die jeweils sich gegenüber liegende Paare von Kontakten (4,5) bilden, wobei nur ein Teil der sich gegenüber liegenden Paare von Kontakten (4,5) erste Kontakte (12) und zweite Kontakte (13) bilden.

5. Elektronische Leiterplatte (1) nach Anspruch 3 oder 4, wobei der Logikbaustein (11) in der Lage ist, elektronische Änderungen, die durch eine mit einem Stecker hergestellte elektrische Verbindung zwischen einem ersten Kontakt (12) auf der Oberseite (2) und einem zweiten Kontakt (13) der Unterseite zu erkennen und anhand von solchen erkannten Veränderungen, das Vorhandensein des Steckers zu signalisieren.

6. Stecker für eine elektronische Leiterplatte (1) nach einem der vorhergehenden Ansprüche, wobei der Stecker (5) eine Kontaktklammer (7) zur Verbindung des ersten Kontaktes (12) mit mindestens einem zweiten Kontakt (13) aufweist.

7. Stecker nach Anspruch 6, wobei der Stecker an ein mehradriges Kabel (8) angeschlossen ist, wobei für jede Ader (9) eine Kontaktklammer (7) vorgesehen ist.

8. Stecker nach Anspruch 6 oder 7, aufweisend eine Aufnahmenut, mit der der Stecker einfach auf die Kontaktleiste aufgeschoben werden kann, wobei innerhalb der Aufnahmenut mindestens eine Kontaktklammer (7) vorgesehen ist.

9. Schaltung für eine elektronische Leiterplatte (1) nach einem der vorhergehenden Ansprüche 1 bis 5, wobei der erste Kontakt (12) über einen ersten Widerstand (16) mit einem positiven Spannungspotential verbunden ist und der zweite Kontakt (13) mit Masse oder einem negativen Spannungspotential oder umgekehrt.

10. System bestehend aus einer elektronischen Leiterplatte (1) nach einem der Ansprüche 1 bis 5 und einem Stecker nach einem der Ansprüche 6 bis 7.

11. Verfahren zum Erkennen des Vorhandenseins eines Steckers (6) mit einem mehradrigen Kabel (8) auf einer Kontaktleiste (22) aus mehreren Kontakten (4, 5), insbesondere auf einer elektronischen Leiterplatte (1) nach einem der Ansprüche 1 bis 5, wobei ein Logikbaustein (11) mindestens einen ersten Kontakt (12) der Kontakte (4, 5) elektronisch überwacht und aus dessen elektronischen Eigenschaften auf das Vorhandensein oder Nichtvorhandensein des Steckers (6) schließt.

12. Verfahren nach Anspruch 11, wobei der erste Kontakt (12) und ein zweiter Kontakt (13) mit unterschiedlichen elektrischen Bauelementen verbunden werden.

13. Verfahren nach Anspruch 12, wobei der erste Kontakt (12) über mindestens einen Widerstand (16,17) mit einem positiven Spannungspotential und der zweite Kontakt (13) mit Masse (14) oder einem negativen Spannungspotential verbunden werden oder umgekehrt.

14. Verfahren nach Ansprüche 11 bis 13, wobei der Logikbaustein (11) das Spannungspotential am ersten Kontakt (12) erfasst und daraus das Vorhandensein oder Nichtvorhandensein eines Steckers erkennt und diese Information weiterleitet.
